# EUROPEAN PATENT APPLICATION

(11) **EP 2 687 352 A2**
(43) Date of publication of application: **22.01.2014**
(21) Application number: 12757472.1
(22) Date of filing: 14.03.2012
(51) Int. Cl.: B29C 59/14, B29C 45/00, B29C 71/04

(54) **SURFACE MODIFICATION METHOD OF PLASTIC INJECTION MOLDED PRODUCT, AND INJECTION MOLDED PRODUCT PREPARED THEREBY**

(30) Priority: 14.03.2011 KR 20110022218; 20.12.2011 KR 20110138644
(71) Applicant: Nada Innovation Co., Ltd, Asan-si, Chungnam 336-745 (KR)
(72) Inventor: KANG, Myung Ho, Seoul 137-937 (KR)
(74) Representative: Beier, Ralph
(86) International application number: PCT/KR2012/001826
(87) International publication number: WO 2012/124971

(57) **Abstract**

Provided is a method for reforming a surface of a plastic injection-molded article. The method includes (a) a step of preparing a plastic injection-molded article provided with a front surface having a surface roughness of 20 *µ*m or less and a rear surface, and (b) a step of implanting ions or electrons into the front surface of the plastic injection-molded article while cooling the rear surface of the plastic injection-molded article.

## Description

### Technical Field

The present invention relates to a method for reforming a surface of a plastic injection-molded article and an injection-molded article produced by the method.

### Background Art

Ion implantation refers to a technology in which ionized atoms are accelerated and are forcibly implanted into a surface of a target object, thereby changing a composition, a bonding state and a crystal structure of the surface and improving the surface properties.

If the technology is used in implanting ions into a surface of an object such as a metal, a semiconductor, a ceramic or a polymer and eventually changing the properties of the object surface, there is provided commercial applicability in many different fields. The implantation of ions into a surface of a target object makes it possible not only to improve object surface properties, such as friction resistance, wear resistance, corrosion resistance, hardness, color and the like, but also to apply electric conductivity to a nonconductor such as a polymer or the like.

There are known many different methods by which ions accelerated with a high level of energy are implanted into a surface of an object to be subjected to surface treatment. In a typical ion implantation method, ions generated in a plasma generating device are extracted and are formed into an ion beam through a focusing process. Then, the ion beam is accelerated and injected on a surface of a target object. In a plasma source ion implantation (PSII) method, an object to be surface-treated by ion implantation is placed on a table existing within a chamber filled with plasma. If negative high voltage pulses are applied to the object, ion acceleration occurs in a transition plasma sheath generated around the surface of the object. The accelerated ions voluntarily impinge against the surface of the object applied with the negative high voltage pulses.

### Summary of the Invention

### Technical Problems

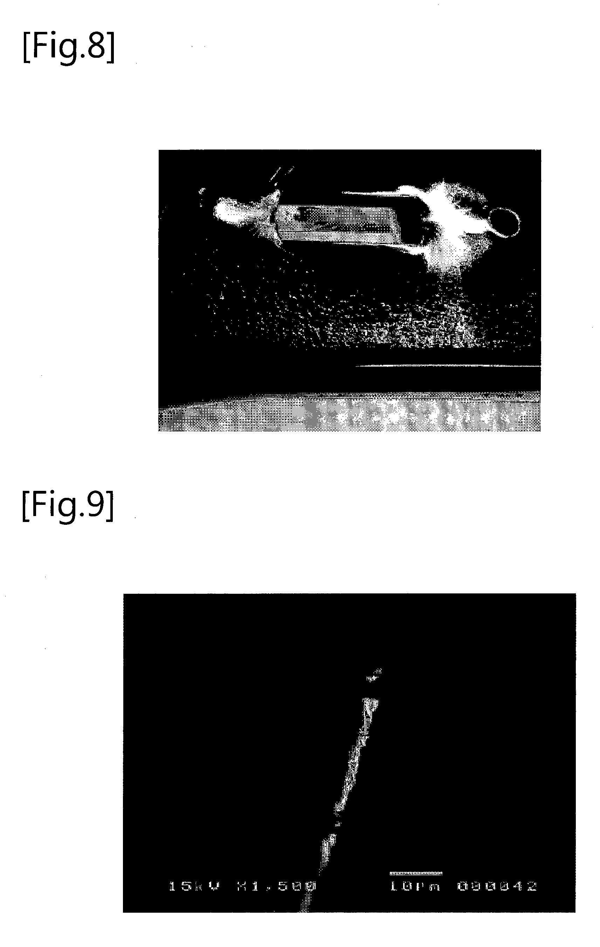

An attempt has been made to improve the surface properties of an injection-molded article using an ion implantation method. However, if ions are implanted into the surface of the injection-molded article, there are posed problems such as deformation of the surface of the injection-molded article, generation of stains on the surface of the injection-molded article, carbonization of the surface of the injection-molded article, and recurrence of weld lines, as shown in Fig. 8.

In general, injection-molded plastic articles are flat articles whose width is at least five times as large as the thickness thereof. When a resin flows into a flat cavity of a mold, the resin advances like a fountain wile forming a frozen layer on the wall surface of the mold. This resin flow is called a fountain flow. Under this principle, the resin contained in a front portion of a barrel of an injection molding machine is used in forming a surface layer of an article. The resin contained in a rear portion of the barrel is filled in a central region of the article. An interface between a solidified layer and a flowing layer is a portion having a largest shear strain. A surface layer is rapidly solidified and a central portion is lastly solidified. Thus, the surface layer is larger in directivity than the central portion.

The present inventor has repeatedly conducted a test in which ions or electrons are implanted into a surface of a injection-molded article. The present inventor found that surface defects are largely generated by fine air bubbles remaining on the surface of the injection-molded article. A surface of a typical injection-molded article is high in directivity due to the fountain flow and is low in density due to the increased amount of air bubbles. If ions or electrons are implanted into a surface on which fine air bubbles remain, a gas existing within the air bubbles is expanded under the influence of energy and is released to the outside, thus leaving deformations or stains on the surface. Moreover, the air bubbles existing in deeper positions distant from the surface are not released to the outside but are left inside the surface. These air bubbles are expanded under the influence of energy, eventually deforming the surface. It is sometimes the case that the surface of the injection-molded article is melted or carbonized by the high energy of ions implanted in an ion implantation process.

In case where the surface properties of an injection-molded article are improved by implanting electrons into the surface of the injection-molded article through the irradiation of an electron beam, just like the case where the surface properties of an injection-molded article are improved by implanting ions, there are posed problems in that the surface luster becomes uneven and the surface is deformed or carbonized.

It is an object of the present invention to provide a method for reforming a surface of a plastic injection-molded article, which is capable of implanting ions or electrons into the surface of the injection-molded article without generating deformations or stains on the surface of the injection-molded article.

Another object of the present invention is to provide a plastic injection-molded article which is implanted with ions or electrons with no generation of deformations or stains on the surface thereof.

### Technical Solutions

According to one aspect of the present invention, there is provided a method for reforming a surface of a plastic injection-molded article, including: (a) a step of preparing a plastic injection-molded article provided with a front surface having a surface roughness of 20 *µ*m or less and a rear surface; and (b) a step of implanting ions or electrons into the front surface of the plastic injection-molded article while cooling the rear surface of the plastic injection-molded article.

Air bubbles should not remain in a surface layer of the injection-molded article whose front surface is to be reformed. Little air bubbles remain in the surface layer of the injection-molded article having a surface roughness of 20 *µ*m or less. According to the present invention, even if ions or electrons are implanted into the front surface of the injection-molded article, little air bubbles remain in the surface layer of the injection-molded article. Thus, deformations or stains are not generated on the front surface of the injection-molded article. Moreover, according to the present invention, the rear surface of the injection-molded article is cooled during the implantation of ions or electrons, whereby air bubbles remaining in a compressed state at a predetermined depth or less from the surface layer are prevented from being released to the front surface due to the heating of the surface layer.

In the method of the present invention, the step (a) includes: (a-1) a step of heating a cavity of a mold to a first temperature which is equal to or higher than one half of a melting temperature (Tm) of a resin composition but equal to or lower than a decomposition temperature of the resin composition; (a-2) a step of injecting a molten resin composition into the cavity of the mold; (a-3) a step of obtaining an injection-molded article by cooling the cavity of the mold to a second temperature, which is equal to or lower than a crystallization temperature (Tc) of the resin composition, at a cooling speed of from 200 to 400°C/min; and (a-4) a step of removing the injection-molded article.

In the method of the present invention, the step (b) includes: (b-1) a step of positioning the injection-molded article on a table existing within a chamber of an ion or electron implantation device; and (b-2) a step of implanting ions or electrons into the front surface of the injection-molded article while cooling the table.

In the method of the present invention, in the step (b-2), the table is cooled by cooling water which circulates through the table.

In the method of the present invention, in the step (b-2), the table is cooled by a cold energy storage material making contact with the table.

In the method of the present invention, in the step (b-2), the table is cooled by a Peltier element installed in the table.

In the method of the present invention, the table includes a surface making contact with the rear surface of the injection-molded article, the surface of the table conforming in shape to the rear surface of the injection-molded article such that the table makes close contact with the injection-molded article.

In the method of the present invention, a container containing a cold energy storage material is arranged between the table and the injection-molded article, the container including a surface making contact with the rear surface of the injection-molded article, the surface of the container conforming in shape to the rear surface of the injection-molded article such that the container makes close contact with the injection-molded article.

According to another aspect of the present invention, there is provided a plastic injection-molded article which includes a front surface having a surface roughness of 20 *µ*m or less, the front surface reformed by implantation of ions or electrons.

### Advantageous Effects

According to the present method for reforming a surface of a plastic injection-molded article, injection molding is performed at a high temperature. This makes it possible to minimize the directivity of a surface layer attributable to a fountain flow and to increase the density. It is therefore possible to prevent the surface luster from becoming uneven. Furthermore, the injection-molded article is cooled during ion implantation. It is therefore possible to prevent the injection-molded article from being melted or carbonized by the high energy of ions implanted into the injection-molded article. According to the present method for reforming a surface of a plastic injection-molded article, it is possible not only to improve the surface properties of the injection-molded article, such as friction resistance, wear resistance, corrosion resistance, hardness, color and the like, but also to apply electric conductivity to the injection-molded article.

### Brief Description of the Drawings

Fig. 1 is a sequence diagram illustrating a method for reforming a surface of a plastic injection-molded article according to one embodiment of the present invention.
Fig. 2 is a schematic section view showing a separable mold used in the method according to one embodiment of the present invention, in which view the mold is kept in an open state.
Fig. 3 is a schematic section view showing the separable mold used in the method according to one embodiment of the present invention, in which view the mold is kept in a closed state.
Figs. 4A and 4B are conceptual diagrams comparatively showing an injection molding method according to the present invention and a conventional injection molding method.
Figs. 5A and 5B are photographs showing a surface of an injection-molded article produced by the injection molding method of the present invention and a surface of an injection-molded article produced by a conventional injection molding method.
Fig. 6 is a schematic diagram showing an ion implantation device used in the method according to one embodiment of the present invention.
Fig. 7 is a schematic diagram showing another ion implantation device used in the method according to one embodiment of the present invention.
Fig. 8 is a photograph showing defects which are generated on a surface of a typical plastic injection-molded article implanted with ions.
Fig. 9 is an electron microscope photograph showing a surface of a typical plastic injection-molded article.
Fig. 10 is a graph representing the roughness of a surface of a typical plastic injection-molded article.
Fig. 11 is an electron microscope photograph showing a surface of a plastic injection-molded article having a surface layer on which air bubbles do not remain.
Fig. 12 is a graph representing the roughness of a surface of a plastic injection-molded article having a surface layer on which air bubbles do not remain.
Fig. 13 is a photograph showing an ion-implanted surface of a plastic injection-molded article having a surface layer on which air bubbles do not remain.

### Mode for Carrying out the Invention

Certain embodiments of the present invention will now be described in detail with reference to the accompanying drawings.

### [First Embodiment]

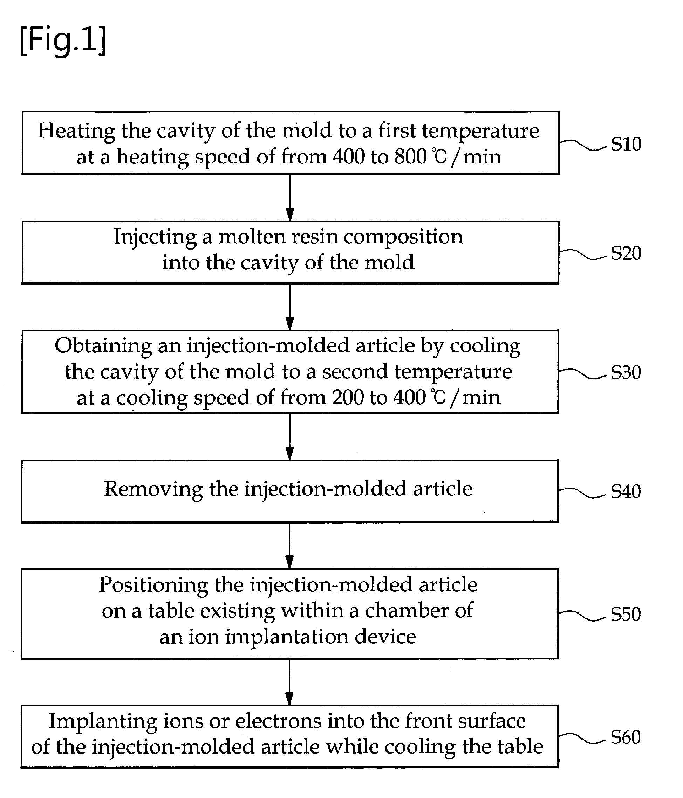

Fig. 1 is a sequence diagram illustrating a method for reforming a surface of a plastic injection-molded article according to a first embodiment of the present invention. A method for reforming a surface of a plastic injection-molded article according to the present embodiment includes a step of producing an injection-molded article having a high-density surface and a step of implanting ions into the injection-molded article.

The step of producing an injection-molded article having a high-density surface includes a step (S10) of heating a cavity of a mold to a first temperature, which is equal to or higher than one half of a melting temperature (Tm) of a resin composition but equal to or lower than a decomposition temperature of the resin composition, at a heating speed of from 400 to 800°C/min, a step (S20) of injecting a molten resin composition into the cavity of the mold, a step (S30) of obtaining an injection-molded article by cooling the cavity of the mold to a second temperature, which is equal to or lower than a crystallization temperature (Tc) of the resin composition, at a cooling speed of from 200 to 400°C/min, and a step (S40) of removing the injection-molded article.

The resin composition used in the present embodiment may preferably be, but is not limited to, a mixture of one or more resins selected from the group consisting of high-density polyethylene, polypropylene and polystyrene and one or more copolymers selected from the group consisting of an ethylene-propylene copolymer, an ethylene-octene copolymer, an ethylene-propylene-diene copolymer, an ethylene-butyl copolymer and a styrene-ethylene/butylene-styrene copolymer.

The high-density polyethylene, the polypropylene and the polystyrene are thermoplastic resins capable of realizing high flexural strength. The ethylene-propylene copolymer, the ethylene-octene copolymer, the ethylene-propylene-diene copolymer, the ethylene-butyl copolymer and the styrene-ethylene/butylene-styrene copolymer are resins capable of enhancing impact strength. By mixing these resins, it is possible to enhance brittleness.

No particular restriction is imposed on a method of mixing the resin components. For example, the resin components mentioned above can be uniformly mixed by a mixing machine or a kneading machine widely used in the field of resins, such as an extruder, a kneader, a Banbury mixer, a Henschel (registered trademark) mixer or a planetary mixer.

A mold cavity temperature, a heating speed and a cooling speed are important molding conditions which have to be strictly controlled in the injection molding step. No particular restriction is imposed on a method of controlling the mold cavity temperature, the heating speed and the cooling speed. It may be possible to use, e.g., a temperature profile mold capable of circulating water or oil therethrough or capable of accurately controlling the temperature thereof or the cavity surface temperature with a mold heater. Moreover, it may be possible to use a molding method in which the mold temperature is set equal to a cooling temperature of the resin composition and in which the cavity surface is temporarily heated, just prior to molding, by induction heat, infrared rays, ultrasonic waves, electric fields, magnetic fields or flame. No particular restriction is imposed on injection molding conditions such as the measurement, the injection speed, the injection pressure, the secondary pressure and the mold tightening force.

In the present embodiment, a separable mold called an E-MOLD (commercialized by the present applicant), which makes use of an ultra-high temperature heating technology, is used in an injection molding device for satisfying the aforementioned injection molding conditions.

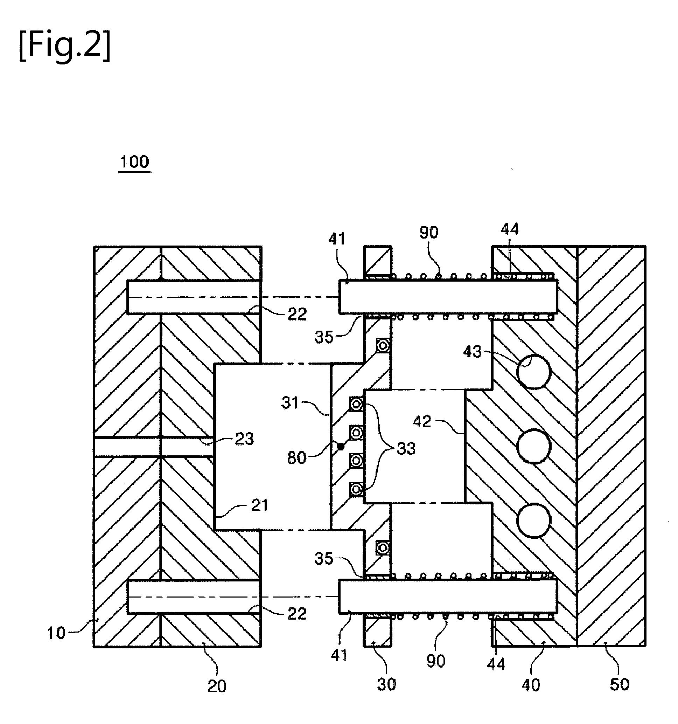

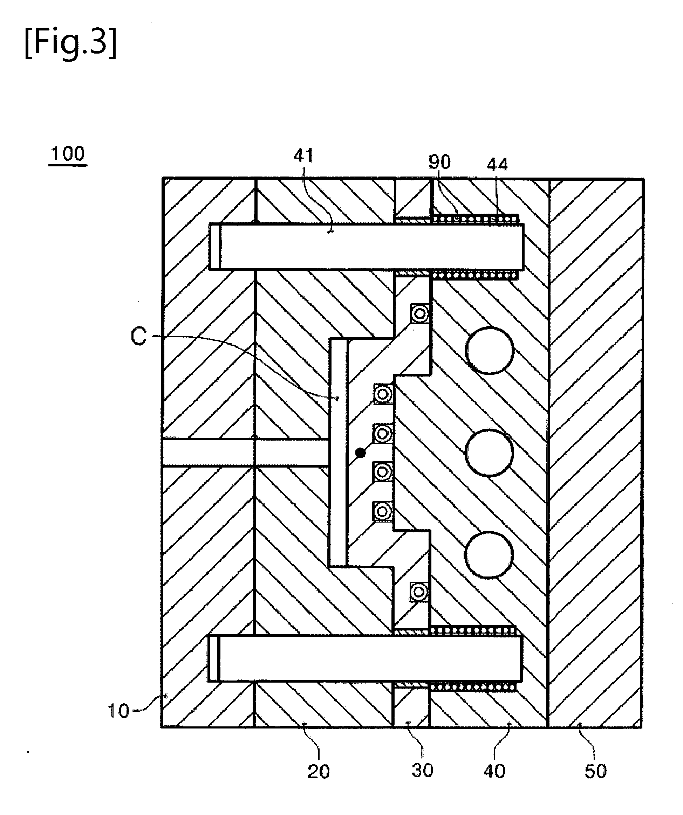

Fig. 2 is a schematic section view showing a separable mold used in the method according to one embodiment of the present invention, in which view the mold is kept in an open state. Fig. 3 is a schematic section view showing the separable mold used in the method according to one embodiment of the present invention, in which view the mold is kept in a closed state. As shown in Figs. 2 and 3, a mold device used in the present embodiment includes a cavity mold 20 fixed to an injection molding machine not shown, a middle core mold 30 installed to slide toward or away from the cavity mold 20 under the guidance of guide pins 41, and a core mold support plate 40 fixed to a core mold fixing plate 50 movably attached to the injection molding machine, the guide pins 41 inserted into bushes 35 of the middle core mold 30 and fixed to the core mold support plate 40. The cavity mold 20 has a cavity surface 21 toward which a molten resin composition is injected. An injection path 23, through which the molten resin composition is injected, is connected to the cavity surface 21. The cavity mold 20 has guide holes 22 into which the guide pins 41 are inserted. The middle core mold 30 has a core surface 31 facing toward the cavity surface 21. The core surface 31 and the cavity surface 21 cooperate to define a cavity C into which the molten resin composition is injected. The middle core mold 30 is formed into a plate shape to have a thickness smaller than the thickness of the core mold support plate 40 so that the middle core mold 30 can be heated and cooled with ease. The middle core mold 30 is formed by separating a conventional core mold.

An injection molding method using the injection molding device provided with the separable mold is performed as follows. In a state in which the mold device 100 of the present embodiment is installed in the injection molding device, an electric current is supplied to an electric heater, thereby heating the middle core mold 30 to a first temperature which is equal to or higher than one half of a melting temperature (Tm) of the resin composition but equal to or lower than a decomposition temperature of the resin composition. At a temperature lower than one half of the melting temperature (Tm) of the resin composition, the molten resin composition moves forward while forming a frozen layer on the surface of the cavity. Thus, flow marks or voids are formed on the surface of the injection-molded article, consequently reducing the density of the surface of the injection-molded article. Such a surface state becomes a cause of making the surface luster uneven after ion implantation. At the temperature higher than the decomposition temperature of the resin composition, the resin composition is decomposed to thereby generate gases. Thus, voids are formed on the surface of the injection-molded article, eventually reducing the density of the surface of the injection-molded article.

The middle core mold 30 has a reduced thickness and, therefore, can be heated at a heating speed of from 400 to 800°C/min. At the same time, cooling water is caused to flow through a cooling water pipe 43 of the core mold support plate 40, thereby cooling the core mold support plate 40 so as to maintain a temperature required for efficient cooling.

If the middle core mold 30 and the core mold support plate 40 reach a temperature suitable for an injecting operation and a cooling operation, the core mold fixing plate 50 is moved leftward (toward the cavity mold 20) in Fig. 2 so that the cavity mold 20, the middle core mold 30 and the core mold support plate 40 can be pressed against one another (a mold device closing operation).

Next, a molten resin composition is injected into the cavity C defined between the cavity mold 20 and the middle core mold 30. The electric heater is turned off during or after the injection of the molten resin composition. If the electric heater is turned off, the middle core mold 30 is rapidly cooled by the core mold support plate 40 which stays cold. The cavity mold 20 making contact with the middle core mold 30 is also rapidly cooled to a second temperature at a cooling speed of from 200 to 400°C/min.

Upon finishing the injection and solidification of the molten resin composition, the core mold fixing plate 50 is moved backward (rightward in Figs. 2 and 3), thereby removing the guide pins 41 from the guide holes 22 (a mold device opening operation). At this time, the middle core mold 30 is detached from the core mold support plate 40 by the restoring force of coil springs 90 and is no longer cooled. Simultaneously, an electric heater 33 is turned on to heat the middle core mold 30. The injection-molded article is removed from the cavity C. The injection molding is performed by repeating the aforementioned steps.

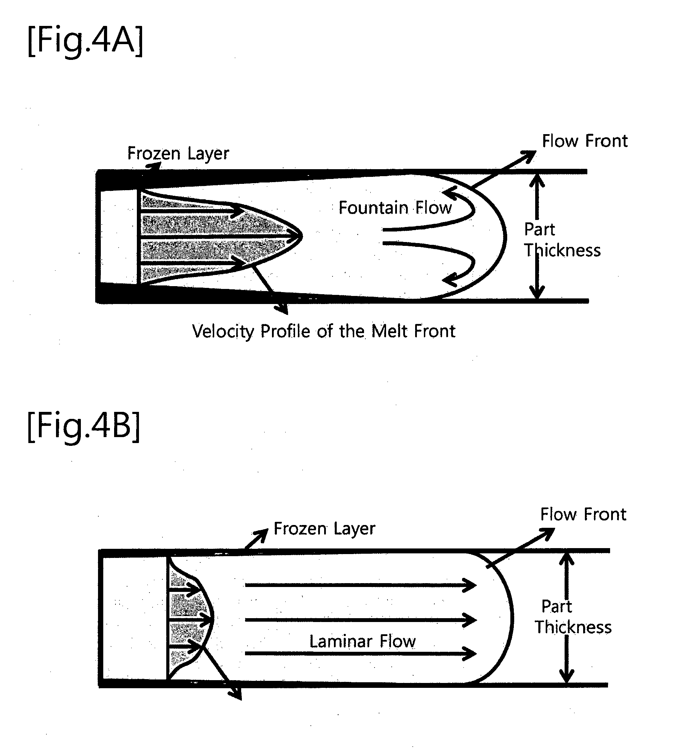

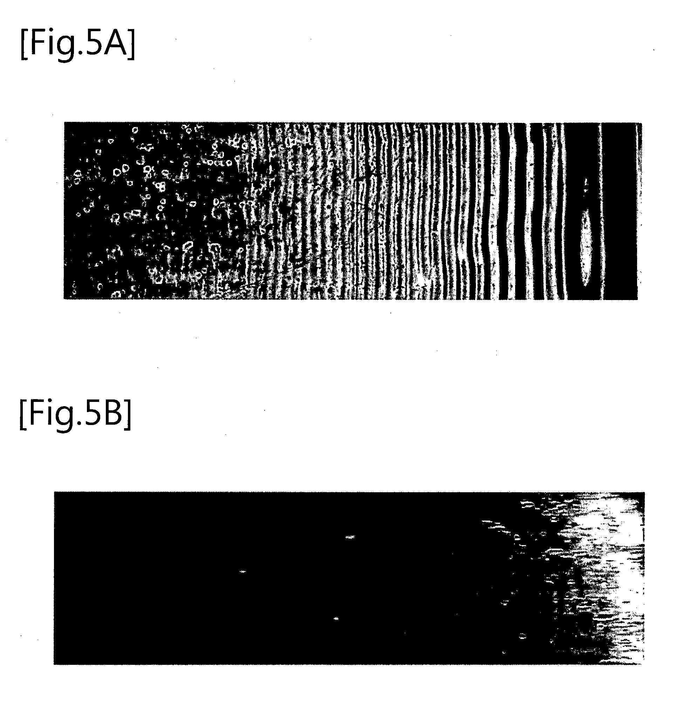

Figs. 4A and 4B are conceptual diagrams comparatively showing an injection molding method according to the present invention and a conventional injection molding method. Figs. 5A and 5B are photographs showing a surface of an injection-molded article produced by the injection molding method of the present invention and a surface of an injection-molded article produced by a conventional injection molding method. Figs. 4A and 5A are directed to a conventional injection molding method. Figs. 4B and 5B are directed to an injection molding method according to the present invention. In the conventional injection molding method, an injection-molded article is produced by injecting a molten resin composition into a cavity of a mold through which cooling water flows. As can be seen in Fig. 4A, the temperature of the cavity of the mold is kept low in the conventional injection molding method. For that reason, the molten resin composition moves forward like a fountain flow while forming a frozen layer on the surface of the cavity. As shown in 5A, due to the formation of the frozen layer, the surface layer of the injection-molded article is large in directivity. Flow lines are formed on the surface of the injection-molded article. Moreover, voids are formed on the surface of the injection-molded article and the density of the surface of the injection-molded article is low. In the injection molding method according to the present invention, as illustrated in Fig. 4B, the molten resin composition is allowed to flow with the mold heated to a high temperature. For that reason, a frozen layer is scarcely formed on the surface of the cavity. Thus, the molten resin composition moves forward in the form of a laminar flow. As can be noted in Fig. 5B, the surface layer of the injection-molded article is small in directivity and high in density.

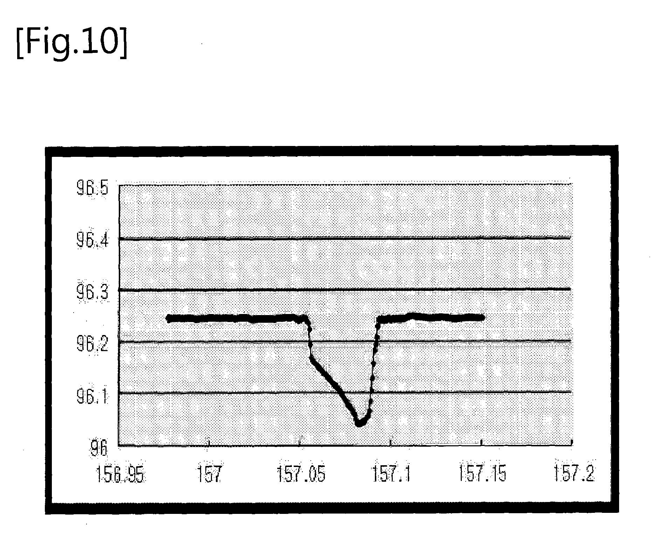

Fig. 9 is an electron microscope photograph showing a surface of a typical plastic injection-molded article near a weld line. Fig. 10 is a graph representing the roughness of the surface of the typical plastic injection-molded article near the weld line. A groove having a depth of about 230 *µ*m is formed around the weld line of the typical plastic injection-molded article. Fine air bubbles remain along the weld line.

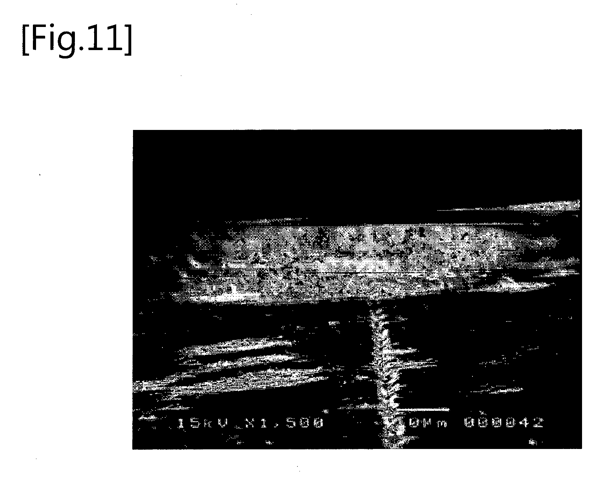

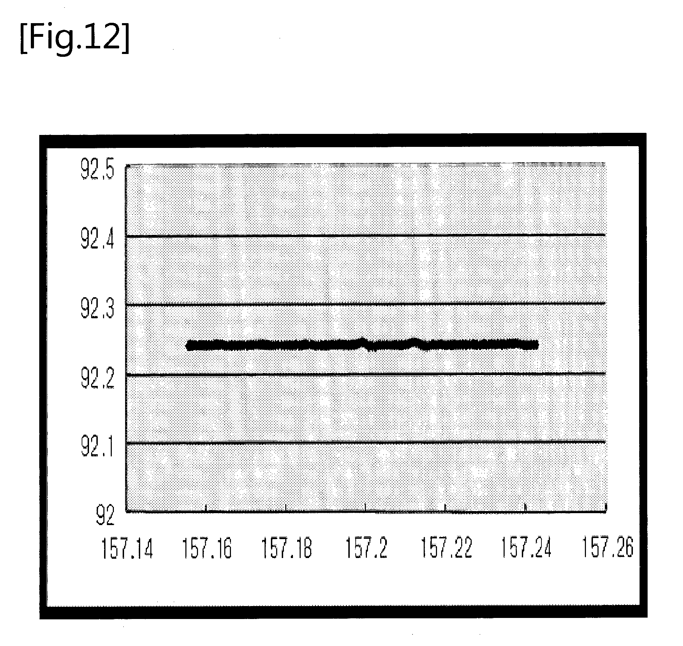

Fig. 11 is an electron microscope photograph showing a surface of a plastic injection-molded article produced according to the method of the present embodiment, which photograph is taken around a weld line. Fig. 12 is a graph representing the roughness of the surface of the plastic injection-molded article produced according to the method of the present embodiment. In the plastic injection-molded article produced according to the method of the present embodiment, a groove having a depth of about 20 *µ*m or less is formed around the weld line. This roughness is substantially the same as the roughness of the surface other than the weld line. Air bubbles do not remain around the weld line.

Referring again to Fig. 1, the step of implanting ions into the injection-molded article includes a step (S50) of positioning the injection-molded article on a table existing within a chamber of an ion implantation device and a step (S60) of implanting ions into the injection-molded article while cooling the table.

If accelerated ions are implanted into the injection-molded article, scission of molecular chains of a polymer, double bonding or cross-linking occurs in the injection-molded article. This leads to a change in the mechanical, electrical and optical properties of the injection-molded article. Using this change, it is possible not only to improve the surface properties of the injection-molded article, such as friction resistance, wear resistance, corrosion resistance, hardness, color and the like, but also to apply electric conductivity to the injection-molded article.

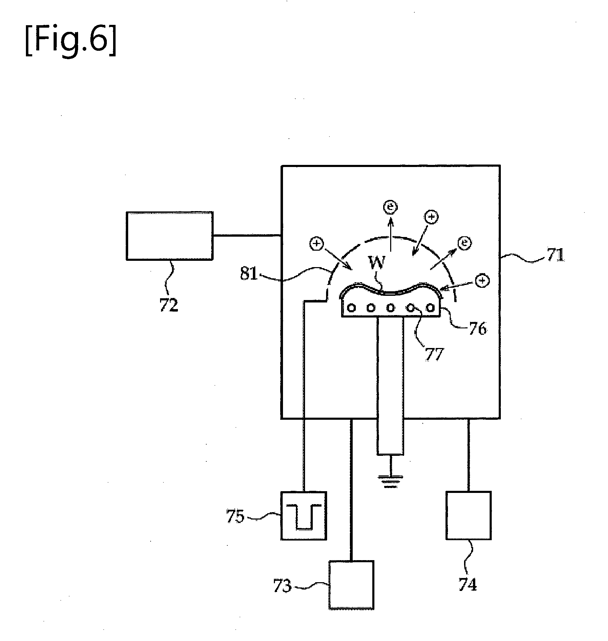

Fig. 6 is a schematic diagram showing an ion implantation device used in the method according to one embodiment of the present invention. The ion implantation device sown in Fig. 6 is a device that implants ions using a plasma source ion implantation (PSII) method.

Referring to Fig. 6, an injection-molded article W is placed on a table 76 installed within a chamber 71. A grid 81 as a conductor is arranged in a position spaced apart by a predetermined distance from the surface of the injection-molded article W. A plasma-generating gas is supplied from a gas supply unit 74 into the chamber 71 in a state in which a suitable vacuum pressure is generated within the chamber 71 by a vacuum pump 73. Plasma is generated within the chamber 71 by the operation of a plasma generator 72. In this state, negative high voltage pulses are applied to the grid 81. In this case, some of the ions accelerated by a plasma sheath formed in the grid 81 are implanted into the grid 81. The remaining ions pass through the grid 81 and reach the surface of the injection-molded article W placed on the table 76. If the energy of the ions arriving at the surface of the injection-molded article W is sufficiently high, the ions are implanted into the surface of the injection-molded article W. In the plasma source ion implantation (PSII) method, the energy of the ions arriving at the injection-molded article W becomes higher as the distance between the grid 81 and the surface of the injection-molded article W becomes shorter. Thus, the ion implantation occurs well. However, if the distance between the grid 81 and the surface of the injection-molded article W is too short, the shadow of the grid 81 appears on the surface of the injection-molded article W. This impairs the uniformity of the ion-implanted surface.

In order to prevent the injection-molded article W from being melted or burnt due to the temperature increase caused by the energy of the accelerated ions during the ion implantation process, a cooling unit 77 is installed in the table 76. The cooling unit 77 prevents a compressed gas remaining within the injection-molded article W from being released to the surface of the injection-molded article W when the temperature of the surface layer of the injection-molded article W is increased to a glass transition temperature or higher by the energy of the ions. This makes it possible to prevent generation of stains or deformation on the surface of the injection-molded article W. The upper surface of the table 76 making contact with the injection-molded article W conforms in shape to the lower surface of the injection-molded article W. Thus, the injection-molded article W makes close contact with the table 76. This assists in increasing the cooling efficiency.

The cooling unit 77 includes a cooling pipe 77 embedded in the table 76. The cooling pipe 77 defines a flow path through which a cooling medium, e.g., cooling water, is circulated.

The cooling unit 77 may use not only the cooling pipe 77 but also a cold energy storage material arranged to make contact with the table 76. The cold energy storage material is cooled under a low-temperature environment so as to store cold energy. If the ambient temperature goes up, the cold energy storage material releases the cold energy, thereby cooling the ambient air. The cold energy storage material is fixed to the table 76 by a fixing means such as a screw, a wire or a clamp. The injection-molded article W staying hot is cooled by the sensible heat and/or the latent heat of the cold energy storage material. As the cold energy storage material, it may be possible to use a phase change material (PCM), water, or other different kinds of liquid materials which are cooled and/or phase-changed to a solid phase at a low temperature and which can, upon the increase of the ambient temperature, release cold energy and maintain the ambient air at a low temperature.

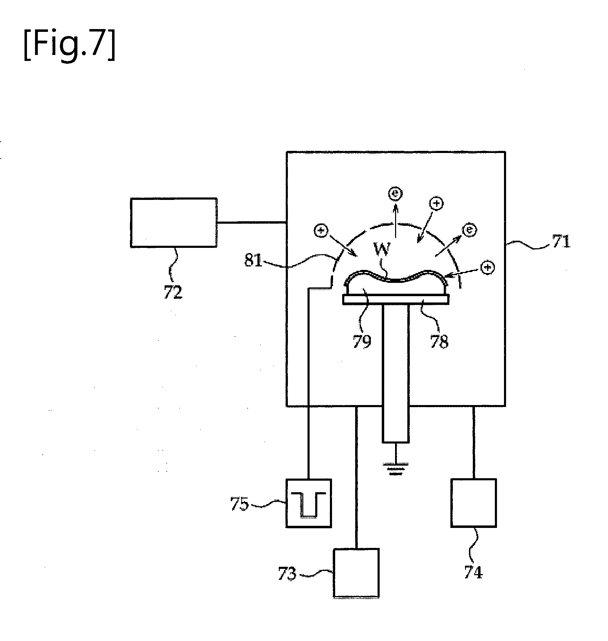

Referring to Fig. 7, as another example of the cooling unit, a container 79 containing a cold energy storage material may be arranged between the table 76 and the injection-molded article W. The upper surface of the container 79 making contact with the injection-molded article W conforms in shape to the lower surface of the injection-molded article W. Thus, the injection-molded article W makes close contact with the container 79. This assists in increasing the cooling efficiency.

As the cooling unit, it may be possible to use a Peltier element installed in the table 76. The Peltier element uses a Peltier effect which is the presence of heating or cooling at an electrified junction of two different conductors. When an electric current is made to flow through a junction between two conductors, heat may be generated or removed at the junction. The Peltier element can control a heat absorption amount depending on the amount of an electric current.

### [Second Embodiment]

A method for reforming a surface of a plastic injection-molded article according to the present embodiment includes a step of producing an injection-molded article having a high-density surface and a step of implanting electrons into the injection-molded article.

The step of producing an injection-molded article having a high-density surface is the same as that of the first embodiment. Therefore, description will be made on only the step of implanting electrons into the injection-molded article.

The step of implanting electrons into the injection-molded article includes a step of positioning the injection-molded article on a table existing within a chamber of an electron beam irradiation device and a step of implanting electrons into the injection-molded article while cooling the table.

An electron beam irradiation device available in the prior art is used as the electron beam irradiation device of the present embodiment. The vacuum degree within the chamber of the electron beam irradiation device is kept at 2×10⁻⁵ Torr or less by means of a vacuum pump. The energy of the electron beam is controlled by an acceleration voltage to become equal to several tens or hundreds KeV.

The irradiation area of the electron beam may be broadened in order to deal with an injection-molded article having a large surface area. In other words, the electron beam irradiation area can be increased by changing an electric current which is supplied to a solenoid for adjusting the size of an electron beam in an electron beam optical system. Alternatively, a broad area may be irradiated using a scan-type electron beam irradiation device.

In order to prevent the injection-molded article from being melted or burnt due to the temperature increase caused by the energy of the accelerated electrons during the electron implantation process, a cooling unit is installed in the table existing within the chamber of the electron beam irradiation device. The table and the cooling unit are the same as those described in respect of the first embodiment and, therefore, will not be described.

While certain preferred embodiments of the invention have been described above, the present invention is not limited to these embodiments. It will be apparent to those skilled in the relevant art that various changes, modifications and substitutions may be made without departing from the scope of the invention defined in the claims.

For example, description has been made on an example in which the plasma source ion implantation (PSII) method is used in implanting ions. Alternatively, the ions generated in a plasma-generating device may be extracted and formed into an ion beam through a focusing process. Then, the ion beam may be accelerated and implanted into a surface of a target object.

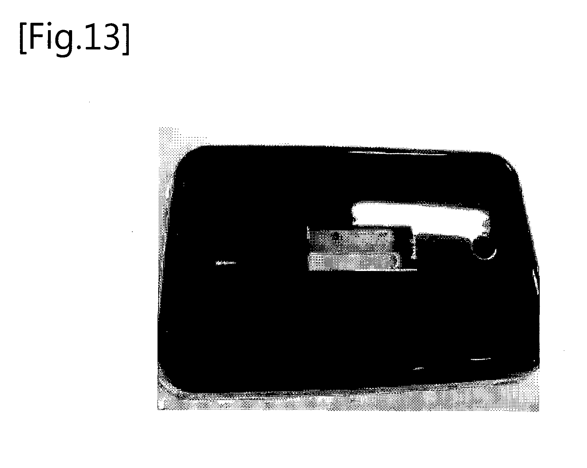

Fig. 13 is a photograph showing one example of a plastic injection-molded article having a surface reformed according to the present method. The electron microscope photograph shown in Fig. 11 and the surface roughness graph shown in Fig. 13 are associated with the plastic injection-molded article illustrated in Fig. 13. The injection-molded article shown in Fig. 13 has a surface roughness of 20 *µ*m or less. Ions are implanted into the surface of the injection-molded article shown in Fig. 13. When producing the injection-molded article shown in Fig. 13, plasma is generated at about 10 Torr using a mixed gas obtained by mixing a nitrogen (N₂) gas and a helium (He) gas in a ratio of 12:8. Ions are implanted using an ion beam injector. During ion implantation, a cold energy storage material staying at 5°C is brought into contact with the rear surface of the injection-molded article, thereby cooling the injection-molded article. As a result of the ion implantation, metallic luster is formed on the surface of the injection-molded article. Air bubbles existing within the injection-molded article are not released to the surface of the injection-molded article. Stains or deformations are not generated on the surface of the injection-molded article.

## Claims

1. A method for reforming a surface of a plastic injection-molded article, comprising:
(a) a step of preparing a plastic injection-molded article provided with a front surface having a surface roughness of 20 *µ*m or less and a rear surface; and
(b) a step of implanting ions or electrons into the front surface of the plastic injection-molded article while cooling the rear surface of the plastic injection-molded article.

2. The method of claim 1, wherein the step (a) comprises:
(a-1) a step of heating a cavity of a mold to a first temperature which is equal to or higher than one half of a melting temperature (Tm) of a resin composition but equal to or lower than a decomposition temperature of the resin composition;
(a-2) a step of injecting a molten resin composition into the cavity of the mold;
(a-3) a step of obtaining an injection-molded article by cooling the cavity of the mold to a second temperature, which is equal to or lower than a crystallization temperature (Tc) of the resin composition, at a cooling speed of from 200 to 400°C/min; and
(a-4) a step of removing the injection-molded article.

3. The method of claim 1, wherein the step (b) comprises:
(b-1) a step of positioning the injection-molded article on a table existing within a chamber of an ion or electron implantation device; and
(b-2) a step of implanting ions or electrons into the front surface of the injection-molded article while cooling the table.

4. The method of claim 3, wherein, in the step (b-2), the table is cooled by cooling water which circulates through the table.

5. The method of claim 3, wherein, in the step (b-2), the table is cooled by a cold energy storage material making contact with the table.

6. The method of claim 3, wherein, in the step (b-2), the table is cooled by a Peltier element installed in the table.

7. The method of claim 3, wherein the table includes a surface making contact with the rear surface of the injection-molded article, the surface of the table conforming in shape to the rear surface of the injection-molded article such that the table makes close contact with the injection-molded article.

8. The method of claim 3, wherein a container containing a cold energy storage material is arranged between the table and the injection-molded article, the container including a surface making contact with the rear surface of the injection-molded article, the surface of the container conforming in shape to the rear surface of the injection-molded article such that the container makes close contact with the injection-molded article.

9. A plastic injection-molded article which includes a front surface having a surface roughness of 20 *µ*m or less, the front surface reformed by implantation of ions or electrons.
